Europäisches Patentamt

European Patent Office

Office européen des brevets

(11) Publication number: **0 489 519 A2**

## EUROPEAN PATENT APPLICATION

(21) Application number: **91310761.1**

(22) Date of filing: **21.11.91**

(51) Int. Cl.5: **H01L 21/314**

(30) Priority: **04.12.90 US 622038**

(43) Date of publication of application:
**10.06.92 Bulletin 92/24**

(84) Designated Contracting States:
**DE FR GB IT**

(71) Applicant: **RAYTHEON COMPANY**
**141 Spring Street**
**Lexington Massachusetts 02173(US)**

(72) Inventor: **Bernstein, Steven D.**
**99 Perry Street, Apt. 6**
**Brookline, Massachusetts(US)**
Inventor: **Wahl, Joseph Matthew**
**85 Hazen Road**
**Shirley, Massachusetts(US)**

(74) Representative: **Jackson, David Spence et al**
**REDDIE & GROSE 16, Theobalds Road**
**London, WC1X 8PL(GB)**

(54) **Sol-gel processing of piezoelectric and ferroelectric films.**

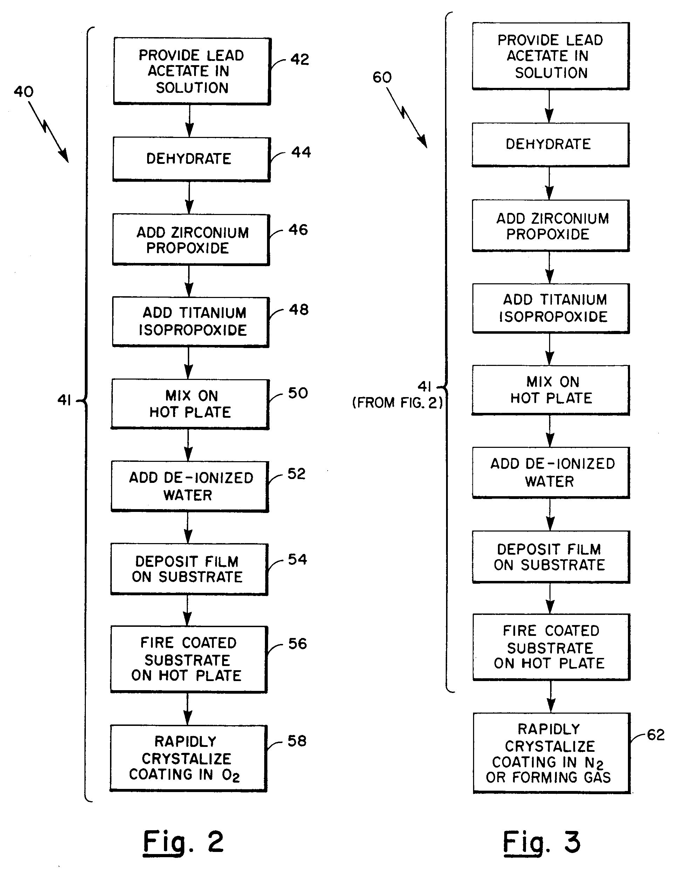

(57) A method of providing a perovskite film having a general chemical formula of $ABO_3$ over a substrate includes the steps of providing (42,44,46,48,50,52) a sol-gel solution of composition of A and B using alkoxides in organic salts and depositing (54) the sol-gel solution as a thin film over the substrate . The film is converted into the perovskite film by rapidly heating (56) the thin film. Preferred perovskite materials include lead zirconate titanate. In one embodiment the films are deposited from sol-gel solutions containing lead, zirconium, and titanium and are converted (58) to a lead zirconate titante crystalline material in an atmosphere of oxygen to provide a ferroelectric dielectric having a high remanent polarization. In an alternate embodiment (Fig. 3), the sol-gel solution of lead, zirconium, and titanium is converted (62) to lead zirconate titanate crystalline material in a non-oxidizing atmosphere of an inert gas, nitrogen, or forming gas to provide materials having high dielectric constants and high and substantially linear dielectric constants with respect to applied voltages.

Fig. 2

EP 0 489 519 A2

Background of the Invention

This invention relates generally to processing of dielectric and, in particular, ferroelectric materials and more particularly to processing of such materials that have useful properties in semiconductor applications.

As it is known in the art, in modern digital computers one of the most commonly used circuits are semiconductor memory circuits. Semiconductor memory circuits generally include several types, random access memory types (RAM), electrically alterable read only memories (EAROM), electrically programmable read only memories (EPROM), and read only memories (ROM). In general, such semiconductor memories are fabricated with transistors, diodes, capacitors, and the like to provide memory elements and associated control circuitry as required. Generally the latter two types EPROM and (ROM) are designed to be programmed only once, the programmable read only memories (PROMs) proms being programmed by electrical means such as breaking electrical paths, whereas the ROMs being programmed during the fabrication process of the device. The first type (i.e. the random access memory) which may be a static or dynamic memory type is designed to be programmed and reprogrammed an indefinite number of times generally on the order of $10^{11}$ times. The RAM is generally used as the basic high speed memory in digital computers. RAMs are characterized as having read cycle times (i.e. data retrieval) and write cycle times (i.e. data storage) of about the same duration.

One problem with these memories is however the memories are generally volatile and not radiation hard. That is, during loss of power or through an upsetting event such as during exposure to ionizing radiation as in a nuclear event the contents of the memory are generally lost. In the latter, the ionizing event causes a sudden increase in photo-induced current which is sensed by the semiconductor devices causing them to change states or at worst destroy the semiconductor resulting in loss of the data in the memory. Thus, as a result of either a loss of power or a nuclear event, the data contained in the memories are lost. In many applications, sudden loss of information in these memories is undesirable. For example, these memories are used in guidance computers in missiles and in satellites which could cause upset and failure of the system. Moreover, in other computer systems, this could also be a problem.

There are several approaches which have been used to overcome these problems. In critical guidance systems such as ballistic missile and the like, magnetic core memories and more recently plated wire memories are used to insure non-volatility and, in particular, radiation hardness. The plated wire or magnetic core memory approach is undesirable since they are each relatively large and of low density of data storage compared to semiconductor memories. They are also very expensive to build, heavy, and require the need for several high power, power supplies. However, they are "rad-hard" and non-volatile and thus are the best choice available for these critical applications. Another approach has been to provide battery backup to the random access memories. The problem with the battery backup is that it is generally cumbersome and adds increased cost to the circuit. Moreover, battery backup does not address the radiation exposure problems.

The EAROM is likewise not a suitable solution since it does not solve the radiation problem and is not a random access memory. The electrically alterable read only memory is not random access because the write cycle time for such a device is generally an order of magnitude or more greater than the read cycle time making this device unsuitable for random access memory applications.

One approach which is currently being developed to provide a non-volatile radiation hard random access memory is based on the use of ferroelectric materials. Ferroelectric materials such as perovskite materials of the form $ABO_3$ have many useful properties which can be exploited to provide a variety of electronic and optoelectronic devices such as the aforementioned non-volatile memories, as well as optical switches, optical modulators, pyroelectric detectors, integrated circuit artificial intelligence neural networks, and a variety of micromechanical devices.

Returning to the aforementioned non-volatile memory applications, in these applications ferroelectric films are provided over a semiconductor substrate including generally a large number of transistors.

In one type of memory element, the perovskite material film is disposed between a pair of conductors and is used as a polarizable dielectric for a capacitor. The capacitance-voltage characteristic of the capacitor is highly non-linear and, in particular, has a high remanent polarization. That is, depending upon the direction in which the voltage is applied to the capacitor, the direction of polarization of the ferroelectric dielectric in the capacitor will vary. This variation in polarization, therefore, can be exploited in a memory to provide a logic one or a logic zero (i.e. digital data bit) stored in the particular location of the memory. Since a principal driving force in all semiconductor memory applications is to increase the density of bits (or i.e. memory cells which can be located in a given area of semiconductor memory), it is generally desirable to have the capacitors formed adjacent to and over the transistors used to address individual memory elements of the semiconductor memory. Other arrangements for memories, as well as other uses of such perovskite materials, may require them to be disposed on unstable or easily oxidized or reduced material substrates. These requirements, therefore, impose severe constraints on the fabrication process used to form the perovskite materials.

For example, when the ferroelectric layers are sandwiched between a pair of conductive layers formed over these substrates, the underlying semiconductor circuits (i.e. transistor and diodes), metal contact layers of the semiconductor, as well as the conducting layers used with the ferroelectric layers to provide the ferroelectric capacitors are extremely susceptible to damage by exposure to high temperatures over long periods of time. Moreover, the type of atmosphere which the metals and semiconductor materials can withstand during processing of the perovskite material imposes limitations for the formation of the perovskite materials.

One ferroelectric material which is useful in the above-mentioned applications is the material known as lead zirconate titanate having the general chemical formula as ($Pb_xZr_yTi_{1-y}O_3$) which will hereinafter be referred to as PZT. Since PZT is a multicomponent material (i.e. a ternary alloy of lead oxide, zirconium oxide, and titanium oxide) controlling composition, as well as the uniformity of composition throughout the film is very important and is, in general, very difficult. Several deposition techniques can be used to provide PZT films. Due to the aforementioned problem of controlling composition however, deposition techniques such as solution gelation techniques (sol-gel) are generally more suitable, since sol-gel processing permits relatively easy control of these ratios compared to other techniques such as vacuum deposition techniques.

One type of sol-gel process is described in a paper entitled "Sol-Gel Processing of $PbTiO_3$, $PbZrO_3$, PZT, and PLZT Thin Films by Budd, et al., the Proceedings of the British Ceramic Society, Vol. 36 (1985), pages 107-121. The authors in this paper describe a procedure in which lead acetate trihydrate, a commonly used lead precursor, is dissolved in an anhydrous solvent such as methoxyethanol. Thereafter, the lead acetate trihydrate solution is dehydrated. To the dehydrated lead acetate is added desired alkyl oxide materials to form a solution which is then deposited on a substrate and fired at a temperature in the range of 400-800°C for an unspecified period of time. The authors further describe that the gels are pyrolyzed in a furnace through which is provided a flowing oxygen atmosphere. The furnace containing the gelled-film is slowly and gradually raised in temperature to the final temperature in the range of 400°C to 800°C. The rate of change in temperature was deliberately done at a slow, controlled heating rate of 10°C per minute. Thus, the authors used a relatively slow rate of change in temperature of the furnace to convert the films into the thin ceramic crystalline coating. The authors apparently chose this technique to prevent cracking in the films as the films are converted from gels into crystalline materials. In particular, for thin PZT films, as opposed to bulk bodies of PZT, the thin PZT films were fired at temperatures of about 700°C as pointed out on page 111 of the paper.

There are several problems with the above approach, for example, temperatures of 700°C would, in general, be very detrimental to integrated circuits over which such materials would be formed and thus this process is not compatible with semiconductor fabrication techniques. This temperature range is particularly detrimental since the gelled PZT is pyrolyzed in an oxidizing atmosphere. Moreover, the films were deposited on so-called "substrates" but apparently were not deposited on metal layers and thus the effect of the firing step in the oxidizing atmosphere on the metal layer which would be used to form a contact for a capacitor can not be ascertained. Therefore, the high temperature oxidizing atmosphere which is used to convert the gels into the lead zirconate titanate crystalline material militates against the usefulness of this sol-gel process to provide a ferroelectric dielectric thin film capacitor on a semiconductor substrate. A further problem, however, involves the use of methoxyethanol as the solvent used in dissolving the lead acetate trihydrate. Methoxyethanol is a known teratogen. That is, methoxyethanol is a severe toxin known to cause genetic mutations in humans. Thus, it is most desirable to eliminate methoxyethanol as the solvent in the sol-gel processing of PZT.

A second sol-gel technique known in the art is described in a paper entitled "Preparation of $Pb(Zr,Ti)O_3$ Thin Films by Sol Gel Processing: Electrical, Optical, and Electro-optic Properties" by Yi, et al., Journal of Applied Physics, Vol. 64, No. 5 (September 1988), pages 2717-2724. With this approach, the authors form a solution of lead acetate trihydrate and acetic acid. That is, the acetic acid, rather than the methoxyethanol, is used to dissolve the lead acetate trihydrate. The solution is then dehydrated. To the dehydrated solution is added zirconium propropoxide and titanium isopropoxide. This solution is then formed into a stock solution by addition of water and ethylene glycol to control the viscosity of the solution. The solution is then spin cast to form a wet film on a substrate and is fired in an oven or furnace at a temperature in the range of 300°C to 500°C to dry and stabilize the film. Thereafter, the film is annealed at 600°C for approximately six hours to form a crystalline PZT film. The authors in this approach have eliminated the use of highly toxic methoxyethanol which is quite desirable. However, the authors still have a process which must be carried out in an unspecified atmosphere at a temperature of 600°C for six hours. This temperature and time duration is highly undesirable for integration with a semiconductor fabrication process. Moreover, the authors report that their materials were deposited on a conductive layer disposed on a glass substrate. The authors also report on the ferroelectric hysteresis properties of their films. The authors indicate that the films exhibit relatively low dielectric constants between 100 and 260, remanent polarization of approximately $6.6\mu C/cm^2$ and relatively high coercive fields ($E_c$) of 26.7 kv/cm. These films thus have electrical properties which are unsuitable for practical applications of PZT in ferroelectric memory applications. The authors also report that the thickness of the films were $1.0\mu m$.

It is also known that, capacitors are used in a wide variety of electronic and microelectronic applications. Frequently, in microelectronic applications large value capacitors are required. The capacitance of on-chip capacitors is limited by the dielectric constant of the dielectric material (typically $SiO_2$ with a dielectric constant of 4) and the area that can be devoted to the capacitor. Because of area constraints, large capacitors typically must be placed off-chip, increasing packaging and assembly costs. In other applications such as dynamic random access memories (DRAMs), the capacitors are required to be fabricated on-chip. The area of the capacitor thus fixes the cell size and ultimately the memory size, independently of reducing cell dimensions by transistor scaling.

These limitations can be overcome by using high dielectric constant materials for the capacitor dielectric. For insertion into integrated circuit applications, the dielectric must be deposited as a thin film between two conducting electrodes (with minimal impact on subsequent processing) to form the capacitor structure. Ferroelectric materials, such as PZT, typically exhibit very high dielectric constants, but, as set forth above, the existing processes to deposit films of these materials require high temperature processing in oxidizing ambients. This thermal treatment damages the underlying silicon circuitry and results in oxidation of the bottom electrode, making subsequent patterning steps extremely difficult and forcing the use of complicated multi-layer bottom electrodes. Furthermore, the polarization hysteresis of the ferroelectric material causes the capacitance to be non-linear with respect to voltage, complicating circuit design tasks and limiting the useful range of operation of the capacitor with respect to applied voltage.

## Summary of the Invention

In accordance with the present invention, a method of providing a perovskite film having the general chemical formula $AB0_3$ over a substrate comprises the steps of providing in a solution A as an organic salt and B as an alkoxide and depositing from said solution a thin film of the material over a substrate. The process further comprises the step of rapidly heating said thin film of the material to convert said thin film of material into the perovskite crystalline material. With such an arrangement, by rapidly heating the thin film, the amount of time over which the substrate is exposed to the high temperature conditions is minimized. This minimizes degradation in the materials of the contact. Furthermore, the films can be converted into crystalline material at overall lower temperatures thereby providing a process which is more suitable for forming perovskite materials on semiconductor circuits.

In accordance with a further aspect of the present invention, a method of forming a lead zirconate titanate film over a substrate comprises the steps of providing in a solution a composition of a lead salt, a zirconium alkoxide, and a titanium alkoxide. The solution is deposited to form a thin film gel over the substrate and the thin film gel and substrate are rapidly heated to convert the thin film gel into the lead zirconate titanate crystalline material. With such an arrangement, by employing a rapid heating step, conversion of the sol-gel solution into crystalline material is provided over shorter time duration. Moreover, the process is also carried out at lower temperatures than prior techniques.

In accordance with a still further aspect of the present invention, a method of providing a lead zirconate titanate film over a substrate comprises the steps of providing in a solution a composition of a lead salt, a zirconium alkoxide, and a titanium alkoxide, depositing said solution over the substrate to a desired thickness, and stabilizing pyrolyzing the film by subjecting the film to a localized heat source to cause portions of the film adjacent said source to initially stabilize while portions further removed from said source are initially unstabilized unpyrolyzed. Continued application of the localized heat causes most of the organics in the thin film gel to be driven off and provides continued, progressive directional stabilization pyrolysis of the film. After sufficient stabilization pyrolysis of the film, the film is then rapidly heated to convert the sufficiently stabilized pyrolyzed film into the lead zirconate titanate crystalline material. With this arrangement, by stabilizing pyrolyzing the film using a uni-directional technique, it is believed that this technique eliminates formation of a stabilized skin layer over the surface of the film. Such surface crusts are formed when the films are stabilized pyrolyzed in a heated atmosphere as in a furnace or oven. These skin layers are believed to interfere with removal of the organics from the gel which could affect properties of the films during and after crystallization. By locally heating the film these organics are allowed to outgas

EP 0 489 519 A2

through unstabilized unpyrolyzed, gel portions of upper surfaces of the film while bottom surfaces thereof stabilize pyrolyze. One example of a localized heat source is a hot plate. By more readily permitting contaminants, in particular, organic contaminants in the film to outgas during the stabilization pyrolyzation process a higher quality and more pure material is provided for conversion into the perovskite crystalline material. Moreover, by rapidly heating the stabilized pyrolyzed film, conversion of the film into a lead zirconate titanate crystalline material is accomplished over shorter durations of time.

In accordance with a still further aspect of the present invention, a layer of a lead zirconate titanate film has a remanent polarization of at least $7.0\mu C/cm^2$ preferably $20.0\mu C/cm^2$ and higher and a coercive voltage of less than about 1 volt. With such an arrangement, a PZT film which has practical use as a ferroelectric dielectric in semiconductor memory applications is provided.

In accordance with a still further aspect of the present invention, a method of providing lead zirconate titanate films having substantially linear dielectric characteristics, with respect to an applied electric field, over a substrate comprises the steps of providing in a gel solution a composition of a lead salt, a zirconium alkoxide, and a titanium alkoxide, depositing said solution over the substrate to a desired thickness, and gradually stabilizing pyrolyzed the film by subjecting the film to a localized heat source to cause portions of the film adjacent to said localized heated source to initially stabilize pyrolyze whereas portions of the film further remove from said localized heated source are initially unstabilized unpyrolyzed. The continued application of the localized heating causes continued progressive stabilization pyrolyzation of the film until the film is satisfactorily stabilized pyrolyzed. The stabilized pyrolyzed film is then rapidly heated in an atmosphere of flowing nitrogen, argon, or forming gas or other such reducing or inert atmosphere to convert the stabilized pyrolyzed film into a lead zirconate titanate crystalline material having substantially linear dielectric properties with respect to an applied electric field. With this arrangement, a technique is provided for forming a dielectric having a very high dielectric permittivity. In particular, such dielectrics can be used as capacitors in dynamic random access memories and the like. Since the dielectric permittivity of the material is high (i.e. at least 40 and on the order of 300 to 1,000 and greater) and is provided by a process which is compatible with semiconductor fabrication techniques, such material can be used to form extremely small capacitors thereby improving packing density of random access memories. Such a dielectric would also be useful for other applications such as providing dielectrics for very small capacitors having relatively high capacitance per unit area ratios for digital, as well as, analog circuits.

In accordance with a still further aspect fo the present invention, a layer of a lead zirconate titanate film having a substantially linear dielectric permittivity with respect to applied voltage of at least 40 and up to 300 to 1,000 and higher is provided. With this arrangement, a very high dielectric constant material is provided. Such material can be used as a dielectric for capacitors in dynamic random access memories and since it has a high dielectric constant, the size of the capacitors can be reduced and accordingly improve the packaging density of such devices.

A preferred embodiment of the invention comprises a layer of lead zirconate titanate, a sample of said layer having a remanent polarization in the range of $6.0\mu C/cm^2$ to $35\mu C/cm^2$ and said sample having a thickness of less than about 3,000Å. ($\mu C$ is written for microcoulombs).

Another preferred embodiment of the invention comprises a layer of lead zirconate titanate, a sample of said layer having a thickness of less than abuot 3,000Å and a coercive voltage in a range of less than 0.5 to 2.0 volts.

A further preferred embodiment of the invention comprises a layer of lead zirconate titanate having a remanent polarization greater than about $7.0\mu C/cm^2$ and a coercive voltage less than about 0.5 to 2.0 volts.

A yet further preferred embodiment of the invention comprises a layer of lead zirconate titanate having a substantially linear dielectric constant with respect to applied voltage in the range of at least 30 to 900., and the layer may be disposed over a metal electrode and said metal electrode be disposed over an integrated circuit.

Brief Description of the Drawings

The foregoing features of this invention, as well as the invention itself, may be more fully understood from the following detailed description of the drawings, in which:

FIGs. 1A-1D are a series of cross-sectional views showing steps in fabricating a typical ferroelectric memory cell having capacitors with a lead zirconate titanate film in accordance with the present invention;

FIG. 2 is a flow chart showing the process steps used in forming lead zirconate titanate films for use as ferroelectric materials and radiation hardened memories in accordance with one aspect of the present invention; and

5

FIG. 3 is a flow chart showing the steps in providing a lead zirconate titanate film having a very high and substantially linear dielectric permittivity in accordance with a further aspect of the present invention.

Description of the Preferred Embodiments

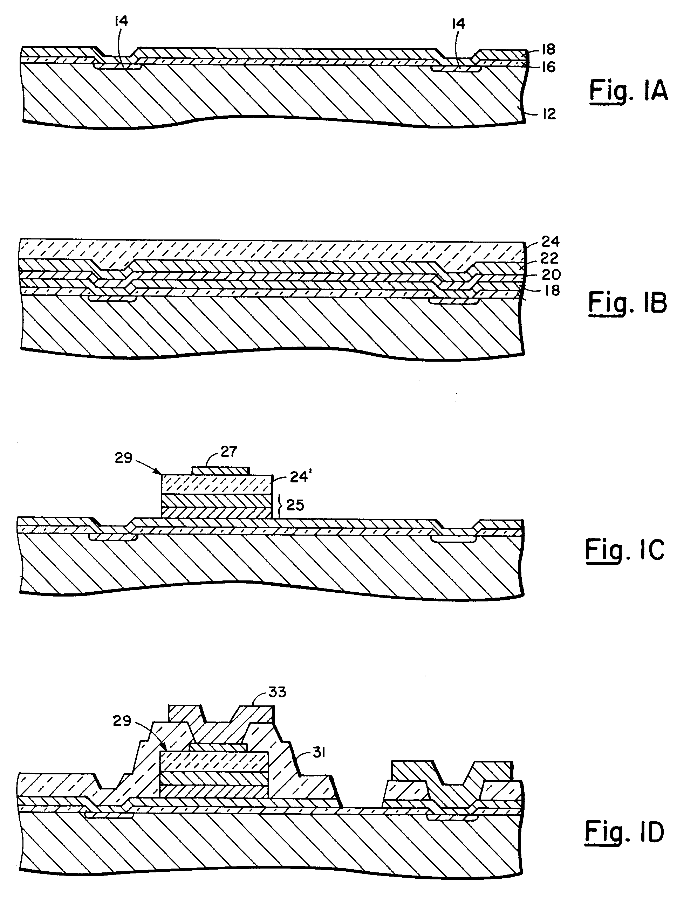

Referring now to FIG. 1A-1D, steps in the fabrication of a ferroelectric device, in particular, a ferroelectric capacitor disposed between a pair of active regions such as transistors, for example, in a silicon substrate will be described.

Referring first to FIG. 1A, a semiconductor substrate 12, here comprised of silicon or alternatively using any other known semiconductor material, is here processed to the point where transistors or other like devices have been provided therein. For example, here are shown implanted regions 14 comprised of suitably doped n-type and/or p-type material to provide transistors or other suitable devices, the exact character of which are not necessary for understanding of the present invention. Disposed over substrate 12 is a layer 16 of here an oxide, preferably an in situ formed oxide of the material of the underlying semiconductor layer 12. Thus, here the layer 16 is comprised of silicon oxide. The silicon oxide layer is etched in a process (not shown) providing windows to expose portions 14 of the device. Disposed in contact over layers 14, as well as over the oxide layer 16, is a layer 18 comprised of a first metal, here said metal being a titanium-tungsten alloy which is used as a barrier layer between the silicon oxide or silicon contact windows and subsequent layers to be deposited thereover. The titanium-tungsten alloy layer 18 forms part of a composite, bottom electrode structure as will be further described below.

Referring now to FIG. 1B, disposed over titanium tungsten layer 18 are sequentially deposited layers of here a titanium layer 20 and a layer 22 of platinum. Here a layer 24 of PZT (i.e. lead zirconate titanate or other perovskite material) is provided using sol-gel processing as will be described in conjunction with FIGs. 2 and 3. Suffice it here to say that the layer 24 provides a dielectric for a capacitor to be formed here, between regions 14, on the substrate 12. More particular, layer 24 is here used to provide a dielectric having non-linear dielectric permittivity characteristics as will be further described in conjunction with FIG. 2. Alternatively, layer 24 may have a relatively high dielectric constant in the range of 30 to 900 which is substantially linear with applied voltage, as will be described in conjunction with FIG. 3.

Referring now to FIG. 1C, a metal layer (not shown) is provided over layer 24 and is patterned using conventional masking and etching techniques (i.e. by backsputtering) to form a top electrode 27. After the top electrode 27 is provided, the ferroelectric layer 24 is etched using conventional masking and etching techniques using buffered hydrogen fluoric acid as an etchant to form an isolated portion 24' disposed over substrate 12 between regions 14 of the device. Alternatively, the isolated portion 24' could be provided over the area 14 of the device. The bottom metal layers 18, 20, and 22 are likewise etched using conventional masking techniques and a combination of a backsputter step to etch the Pt and $T_1i$ (layers 20, 22) and hydrogen peroxide to etch the TiW (layer 18) to provide an isolated contact or bottom electrode 25. The upper electrode contact 27 is here comprised of platinum or alternatively gold, and in combination with the dielectric 24' and contact 25 provides a ferroelectric capacitor 29.

Referring now to FIG. 1D, a layer of an oxide 31 is disposed over the capacitor 29 and a window is opened up in the oxide layer, as shown. A metal layer (not shown) such as an aluminum or TiW/ aluminum composite conductor is deposited through the window to provide a here composite metal contact 33 to the upper electrode 27, as is also shown.

Referring now to FIG. 2, steps in providing a lead zirconate titanate film or other perovskite films having the general chemical formula of $AB0_3$ will now be described. The technique is depicted in the process flow 40 of FIG. 2.

An initial step 42 in providing the lead zirconate titanate film is to first prepare a lead salt solution. Since the sol-gel process using a lead salt and alkoxides precursors of the elements B is water sensitive, all solution fabrication processing should take place in a dry inert atmosphere such as a dry nitrogen atmosphere as could be provided by a dry nitrogen glove box. To provide a suitable solution of the lead salt, here a predetermined amount of lead acetate trihydrate $(Pb(CH_3C00H)_2 \cdot 3H_2O)$ obtained from Aldrich Chemical Company, Milwaukee, Wisconsin, is dissolved in a suitable amount of acetic acid. The acetic acid is used as the solvent. The solution is then dehydrated (step 44) by constantly stirring and heating the solution of lead acetate trihydrate and acetic acid to a temperature in the range of here 105-108°C with 107°C being preferred on a hotplate in an open Erlenmeyer flask. The use of an Erlenmeyer flask rather than a beaker was provided for this step to control the rate of dehydration. The heating process continues until no further boiling of the solution is observed. At this point, the solution has been sufficiently dehydrated and is allowed to partially cool. When the solution has cooled to 80°C, the zirconium alkoxide, here zirconium propoxide obtained from Morton Thiokol and the titanium isopropoxide from Aldrich Chemical Company are individually weighed out in proper amounts of each in individual polyethylene beakers. Polyethylene beakers are used to weigh out the zirconium propoxide and titanium isopropoxide since it is believed that any contaminants picked up in the polyethylene will be easily removed in subsequent thermal processing steps whereas contaminants picked up from a glass beaker or the like may be more difficult to remove. When the temperature of the dehydrated lead acetate solution has reached a predetermined temperature, here of 80°C, the measured amount of zirconium propoxide is added (step 46) into the lead acetate solution followed by the titanium isopropoxide (step 48). This sequence of steps provides suitable results although other sequences of steps could possibly be used. After addition of the zirconium propoxide and titanium isopropoxide, the solution is mixed (step 50) on a hotplate by stirring with a stir bar and gently heating until any solids or gels, which may have formed during the previous addition steps, have been dissolved into solution. At this point, the solution contains a desired ratio between lead, zirconium, and titanium along with organics. The exact composition of the film is controlled by varying the weights of the initial precursors. By varying the composition of the film, its properties may be adjusted to suit particular applications. By varying the quantity of acetic acid the physical and chemical properties of the solution can be adjusted to affect subsequent processing steps.

After the solution has been mixed on the hotplate, the viscosity of the solution is controlled (step 52) by the addition of de-ionized water. Here the solution viscosity is carefully controlled by mixing the PZT solution with the de-ionized water in a ratio of here 2 to 1.0 volumes PZT solution to 1 volume of water. The addition of the deionized water for the PZT solution serves two purposes. The first purpose is to have the water involved in possible hydrolysis condensation reactions which occur during the conversion of the PZT solution to a gel. The second purpose of adding the deionized water is to adjust the solution viscosity so that films of a desired thickness can be provided over a substrate during subsequent deposition processes. The mixture of a PZT solution and water is then filtered prior to deposition. A suitable filtering arrangement would be to use a filter having a 0.2 micrometer pore size or smaller.

For formation of ferroelectric capacitors or high dielectric constant capacitors for use in the aforementioned non-volatile and/or dynamic random access memory applications, a substrate such as shown in FIG. 1, having a metal coating over a first surface thereof is provided. In particular, one metal coating which has been found suitable for formation of ferroelectric capacitors is a coating including a layer of silicon oxide which may be a converted surface portion of a silicon wafer over which is deposited a layer of titanium, a layer of platinum, and then the layer of lead zirconate titanate. An alternative layer arrangement is an alloy of titanium-tungsten over the silicon oxide layer followed by application of a layer of titanium and layer of platinum. The top electrode is Ti over the platinum, or TiW over the platinum each followed by aluminum. In either event, either the Ti-Pt or Ti/W-Ti-Pt composite layers are provided to form a bottom electrode contact for the capacitors. The upper electrode contacts are provided by forming a platinum pattern layer over the PZT after crystallization as will be described. In either event, the wafer having the bottom electrode metal surface is placed in a standard photoresist spinner and the lead, zirconium, titanium organic solution is dispensed (step 54) onto the stationary substrate. Then, the substrate is accelerated to spin at a rate of 1,000 rpm to 7,000 rpm. It spins at this rate for a predetermined period of time. A preferred cycle is 4,500 rpm for 60 seconds. The cycle used is generally related to the viscosity of the solution as prepared in step 52, the desired film thickness and the time required for the film to dry.

Immediately, after the deposition step, the wafer is heated (step 56) by placing it on a hotplate which is disposed at an elevated temperature in the range of 100°C to 400°C here 300°C is used for a predetermined period of time of here 60 seconds. This relatively low temperature baking step serves to drive off solvents from the substrate and to densify the film. Unlike prior approaches in which the stabilizing pyrolyzing step occurs in a oven, the use of a hotplate is seen to provide an advantage to the process. It is believed that the portions of the film disposed on the substrate and thus in close proximity to the hotplate initially stabilize pyrolyze, whereas portions of the layer further removed from the substrate are initially unstabilized unpyrolyzed and only stabilize subsequently by continued heating of the layer. With this arrangement, solvents are driven from the film through the upper portions of the film prior to such upper portions being stabilized pyrolyzed. With the more conventional oven approach, a skin or crust is believed to generally form over the entire film thereby inhibiting removal of solvents and other contaminants from the film. After this baking step 56, the film is stable in air and can be stored for an extended period of time before any subsequent processing occurs.

The above described process generally results in a film having a final thickness of generally less than 3,000Å. If thinner films are desired, it is only necessary to increase spin speed and/or reduce viscosity. Thicker films can be obtained by decreasing spin speed and/or increasing viscosity. Once the single layer thicknesses exceeds 3,000Å, however, cracking is usually a problem in the film. In order to avoid cracking and still provide thicker films, it would generally be desirable to deposit multiple layers with the aforementioned stabilization pyrolyzation heat treatment step 56 being performed between each layer deposition step. Further, separate crystallization step 58 should also be provided, as will be described below. The exact thickness of the film would depend principally upon the requirements for the PZT layer. In general, in capacitor applications for non-volatile RAMs or radiation hardened RAMs, the film thickness of 1,700Å and is particularly in a range of 1,000Å to 2,000Å is generally suitable.

After the films have been stabilized, the films are crystallized 58 by a heat treatment which converts the amorphous organic containing films which have been stabilized on the hotplate into a crystalline film of the perovskite crystalline structure.

As shown in FIG. 2, the conversion step 58 of the amorphous material into the perovskite crystalline material occurs by rapidly heating the film in an atmosphere of flowing oxygen ($O_2$). Two approaches may be used to rapidly heat the film. In one approach, the film coated substrate is placed in a furnace which is already disposed at the desired crystallization temperature which can be a temperature in any suitable range. Temperatures in the range of 400°C up to 600°C are preferred, although temperatures as high as 650°C and higher may be used. However, for compatibility with semiconductor fabrication techniques, generally temperatures in the range of 500°C to below 600°C are preferred. A preferred temperature range employed herein is 550°C.

In one approach, a multi-zone furnace is used. At one end of the furnace the cool end, the substrate is disposed. $O_2$ is purged through the furnace for several minutes. The hot end of the furnace is disposed at the desired temperature and the crystalline substrate is then pushed from the cool end of the furnace into the hot end of the furnace resulting in rapid heating of the substrate. This heating is much more rapid than prior techniques, the rate of change in temperature of the film being on the order of 1°C to 3°C per second (i.e. 60°C to 180°C per minute). This rapid heating should be compared to the relative slow heat rate used in the prior art in which temperatures are gradually changed at a rate of approximately 10° per minute, as for example discussed in the Budd paper. When the sample reaches the desired crystallization temperature which can be monitored by use of a thermocouple, for example, a timer is started and the substrate is held at the crystallization temperature for the predetermined period of time. After the time period has expired, the sample is rapidly pulled from the hot zone to a cool zone at an end of the furnace resulting in rapid cooling. It has been observed with this technique that films are provided free of cracking problems associated with prior techniques and, moreover, the films have high degrees of remanent polarization.

An alternative technique to that mentioned above is to perform the crystalline conversion step in a Rapid Thermal Processor (RTP). In this arrangement, a vessel is provided with flowing oxygen and is heated by quartz halogen lamps. The use of radiant energy from quartz halogen lamps directed on the object to be heated results in extremely rapid thermal heating of the material generally in the range of 6°C to 200°C per second (i.e. 360°C to 12,000°C per minute).

After the films have been crystallized, capacitors are provided by depositing a top electrode over the dielectric film. A suitable material for the top electrode is platinum, although other materials such as gold, aluminum, or other metals or conductive oxides may alternatively be used. The films can be deposited using any conventional technique but ion beam sputtering deposition through a shadow mask is used here as an expedient technique to provide patterned contacts.

Examples of the above described process will now be described.

Examples 1-9

The examples below are believed to have a composition of $Pb_{1.18}Zr_{0.53}Ti_{0.47}O_3$. In practice, the oxygen content could be between about 2.8 to 3.0. That is, the material is a solid solution, somewhat difficult in oxygen. Such a composition was provided by using:

12.00 grams of lead acetate trihydrate $Pb(CH_3COO)_2 \cdot 3H_2O$;

6.579 grams of zirconium propoxide $Zr(C_3H_1O)$; and

3.279 grams of titanium isopropoxide $Ti((CH_3)_2CHO)_4$.

The lead acetate was dissolved in 6 milliliters of acetic acid.

Solutions for the examples were provided by mixing the solution with de-ionized water in a 2 to 1 volume ratio. Each of these solutions were filtered through a 0.2 micrometer pore size filter immediately prior to deposition. The films were then processed at different firing temperatures for different periods of time and had the characteristics as shown in the Table below.

TABLE

| Example | Crystallization Condition | Solution to Water Ratio | Remanent Polarization ($\mu C/cm^2$) | Coercive Voltage ($V_c$) (volts) |
|---|---|---|---|---|
| 1 | 600°C/30 min. | 2:1 | 6.3 | 1 |
| 2 | 500°C/120 min. | 2:1 | 7.0 | 1.3 |
| 3 | 550°C/5 min. | 2:1 | 17.5 | 1.2 |
| 4 | 550°C/10 min. | 2:1 | 19.5 | 1.2 |
| 5 | 550°C/30 min. | 2:1 | 17.1 | 1.1 |
| 6 | 550°C/90 min. | 2:1 | 17.1 | 1.1 |
| 7 | 600°C/5 min. | 2:1 | 25.2 | 1.8 |
| 8 | 600°C/10 min. | 2:1 | 20.2 | 1.2 |
| 9 | 600°C/30 min. | 2:1 | 20.3 | 1.2 |

Referring now to FIG. 3, a sequence of steps 60 used to provide dielectric material having a substantially linear dielectric permittivity with respect to applied voltage is shown to include the sequence of steps 41 generally described in conjunction with FIG. 2. That is, the steps of providing lead acetate trihydrate in a solution of here acetic acid, dehydrating the lead acetate solution, adding zirconium propoxide and titanium isopropoxide and mixing the three constituents on a hotplate. After the constituents are mixed on the hotplate, a solution is provided by adding de-ionized water in a ratio of 2.0-1.0 vol. PZT solution to 1.0 vol. water. The solution is then deposited on a substrate by the spin techniques mentioned above and the coated substrates are baked on a hotplate, as also mentioned above. Here said films, rather than being rapidly crystallized in an atmosphere containing substantially 100% oxygen, are rapidly crystallized (step 62) in an atmosphere containing substantially nitrogen, argon, or other inert or reducing gas, or a forming gas which may include, for example, a predetermined relatively small partial pressure of hydrogen (i.e. approximately 4%) in combination with an inert gas such as helium, argon, and so forth all with a small residual partial pressure of $0_2$ which is generally less than about 1%. The rapid crystallization otherwise occurs as generally described in conjunction with FIG. 2 for step 58. That is, the substrate is placed in a multi-zone furnace having a cool end and a hot end disposed at the crystallization temperature. After purging with the non-oxidizing atmosphere, the substrate is rapidly brought up to the crystallization temperature at a rate of typically greater than 1°C/sec. The crystallization temperature is in the range of 550°C to 700°C. Alternatively, the rapid thermal processor technique as also mentioned in conjunction with FIG. 2 may be used. By rapidly crystallizing the coating in an atmosphere of nitrogen ($N_2$) or forming gas (4% H, balance He, Ar...and so forth) or argon, etc. with a small generally residual partial pressure of $0_2$ a dielectric, crystalline material is provided having a relatively linear dielectric permittivity in the range of 300 up to 900 or higher which does not vary as strongly with applied voltage as the material mentioned above processed in the oxidizing ambient atmosphere. For the forming gas the dielectric permittivity is in the range of 30 to 40.

This particular material is well suited for providing thin film capacitors in dynamic random access memory applications, for example. With the high dielectric constant material provided, smaller capacitors and hence more dense structures may also be provided. This material would also be useful for many analog circuit applications.

Having described preferred embodiments of the invention, it will now become apparent to one of skill in the art that other embodiments incorporating their concepts may be used. It is felt, therefore, that these embodiments should not be limited to disclosed embodiments, but rather should be limited only by the spirit and scope of the appended claims.

## Claims

1. A method of providing a perovskite material having crystal structure over a substrate comprises the steps of:
   providing a combination of precursors of the perovskite materials;
   depositing said precursors over the substrate to provide a film having a thickness; and
   rapidly heating said film to convert said film into the perovskite crystalline material.

2. The method as recited in Claim 1 wherein the heating step occurs by disposing the substrate having the film into a furnace disposed at the desired crystalline forming temperature.

9

3. The method as recited in Claim 1 wherein the rapidly heating step comprises the step of rapidly thermal processing the substrate by exposing the substrate to a sudden increase in temperature at the rate of approximately 1°C to 200°C per second.

4. The method, as recited in Claim 1, wherein the step of rapidly heating occurs in an oxidizing atmosphere.

5. The method, as recited in Claim 4, wherein the heating step in the oxidizing atmosphere occurs by disposing the substrate having the film into a furnace disposed at the desired crystalline forming temperature.

6. The method, as recited in Claim 4, wherein the rapidly heating step in the oxidizing atmosphere comprises the step of rapidly thermally processing the substrate by exposing the substrate to a sudden increase in temperature at the rate of approximately 6°C to 200°C per second.

7. The method, as recited in Claim 1, wherein the rapidly heating step occurs in an inert atmosphere.

8. The method, as recited in Claim 7, wherein the inert atmosphere is selected from the group consisting of nitrogen, an inert gas, or a forming gas comprising hydrogen and an inert gas, or argon.

9. The method, as recited in Claim 7, wherein said heating step occurs by disposing the substrate having the film into a furnace disposed at the desired crystalline forming temperature.

10. The method, as recited in Claim 7, wherein the rapidly heating step comprises the step of rapidly thermally processing the substrate by exposing the substrate to a sudden increase in temperature at the rate of approximately 6°C to 200°C per second.

11. A method of providing a lead zirconate titanate film over a substrate comprises the steps of:
providing in a solution a lead salt, a zirconium alkoxide, and a titanium alkoxide in a predetermined composition ratio;
depositing said solution over the substrate to provide a film having a desired thickness; and
rapidly heating said film to convert said film into the lead zirconate titanate crystalline material.

12. The method, as recited in Claim 11, wherein the lead salt is lead acetate trihydrate, the zirconium alkoxide is zirconium propoxide, and the titanium alkoxide is titanium isopropoxide.

13. The method, as recited in Claim 12, wherein the step of providing the solution further comprises the step of dehydrating the lead acetate trihydrate after dissolving the lead acetate trihydrate in acetic acid.

14. The method, as recited in Claim 13, wherein the step of providing the solution further comprises the step of controlling the viscosity of the solution by introducing deionized water in a ratio of 2.0-1.0 parts solution to 1 part water.

15. The method, as recited in Claim 14, wherein the step of rapidly heating the film comprises the step of introducing the substrate having the film into a furnace disposed at the desired crystalline temperature in the range of 400°C to 650°C.

16. The method, as recited in Claim 15, wherein said furnace is disposed at a temperature in the range of 500°C to less than 600°C for a period of time of less than 40 minutes.

17. The method, as recited in Claim 14, wherein said furnace has flowing therethrough an atmosphere comprised principally of oxygen.

18. The method, as recited in Claim 17, wherein said furnace has flowing therethrough an non-oxidizing atmosphere having a gas selected from the group consisting of nitrogen, argon, inert gas, helium, or forming gas.

19. The method, as recited in Claim 14, wherein the rapidly heating step comprises the step of rapidly thermally processing the substrate to expose the substrate to a sudden increase of temperature in the range of 6°C to 200°C per second.

20. The method, as recited in Claim 18, wherein said heating step occurs in an atmosphere comprised substantially of oxygen.

21. The method, as recited in Claim 18, wherein said heating step occurs in a non-oxidizing atmosphere having a gas selected from the group consisting of nitrogen, argon, helium, inert gas, and forming gas.

22. A method of providing a lead zirconate titanate film over a substrate comprising the steps of:
    providing in a solution a composition of a lead salt, a zirconium alkoxide, and a titanium alkoxide in a predetermined composition ratio;
    depositing said solution over the substrate to provide a film of a desired thickness;
    stabilizing the film by subjecting the coated substrate to a localized heat source to cause portions of the film adjacent to said source to initially stabilize while portions of the film removed from said source are initially unstabilized thereby permitting organics to be driven off through the film; and
    heating said film to convert said film into the lead zirconate titanate crystalline material.

23. The method, as recited in Claim 22, wherein the lead salt is lead acetate trihydrate, the zirconium alkoxide is zirconium propoxide, and the titanium alkoxide is titanium isopropoxide.

24. The method, as recited in Claim 23, wherein the step of providing the solution further comprises the step of dehydrating the lead acetate trihydrate after dissolving the lead acetate trihydrate in acetic acid.

25. The method, as recited in Claim 24, wherein the step of providing the solution further comprises the step of controlling the viscosity of the solution by introducing deionized water in a ratio of 2.0 to 1.0 parts PZT solution to 1 part water.

26. The method, as recited in Claim 25, wherein the step of rapidly heating the film comprises the step of introducing the substrate having the film into a furnace disposed at the desired crystalline temperature in the range of 400°C to 650°C.

27. The method, as recited in Claim 25, wherein said furnace is disposed at a temperature in the range of 500°C to less than 600°C for a period of time of less than 40 minutes.

28. The method, as recited in Claim 25, wherein said furnace has flowing therethrough an atmosphere comprised principally of oxygen.

29. The method, as recited in Claim 26, wherein said furnace has flowing therethrough an non-oxidizing atmosphere having a gas selected from the group consisting of nitrogen, an argon helium, inert gas, or forming gas.

30. The method, as recited in Claim 22, wherein the rapidly heating step comprises the step of rapidly thermally processing the substrate to expose the substrate to a sudden increase of temperature in the range of 6°C to 200°C per second.

31. The method, as recited in Claim 28, wherein said heating step occurs in an atmosphere comprised substantially of oxygen.

32. A layer of lead zirconate titanate, a sample of said layer having a remanent polarization in the range of $6.0\mu C/cm^2$ to $35\mu C/cm^2$ and said sample having a thickness of less than about 3,000Å.

33. A layer of lead zirconate titanate, a sample of said layer having a thickness of less than about 3,000Å and a coercive voltage in a range of less than 0.5 to 2.0 volts.

34. A layer of lead zirconate titanate having a remanent polarization greater than about $7.0\mu C/cm^2$ and a coercive voltage less than about 0.5 to 2.0 volts.

35. A layer of lead zirconate titanate having a substantially linear dielectric constant with respect to applied voltage in the range of at least 30 to 900.

36. The layer of lead zirconate, as recited in Claim 35, wherein said layer is disposed over a metal electrode and said metal electrode disposed over an integrated circuit.

Fig. IA

Fig. IB

Fig. IC

Fig. ID

40

```
   ┌─────────────────┐
   │ PROVIDE LEAD    │── 42
   │ ACETATE IN      │
   │ SOLUTION        │
   └─────────────────┘
          │
   ┌─────────────────┐
   │ DEHYDRATE       │── 44
   └─────────────────┘
          │
   ┌─────────────────┐
   │ ADD ZIRCONIUM   │── 46
   │ PROPOXIDE       │
   └─────────────────┘
          │
   ┌─────────────────┐
   │ ADD TITANIUM    │── 48
   │ ISOPROPOXIDE    │
   └─────────────────┘
          │
   ┌─────────────────┐
   │ MIX ON          │── 50
   │ HOT PLATE       │
   └─────────────────┘
          │
   ┌─────────────────┐
   │ ADD DE-IONIZED  │── 52
   │ WATER           │
   └─────────────────┘
          │
   ┌─────────────────┐
   │ DEPOSIT FILM    │── 54
   │ ON SUBSTRATE    │
   └─────────────────┘
          │
   ┌─────────────────┐
   │ FIRE COATED     │── 56
   │ SUBSTRATE       │
   │ ON HOT PLATE    │
   └─────────────────┘
          │
   ┌─────────────────┐
   │ RAPIDLY         │── 58
   │ CRYSTALIZE      │
   │ COATING IN O2   │
   └─────────────────┘
```

41

## Fig. 2

60

41
(FROM FIG. 2)

```
   ┌─────────────────┐
   │ PROVIDE LEAD    │
   │ ACETATE IN      │
   │ SOLUTION        │
   └─────────────────┘
          │
   ┌─────────────────┐
   │ DEHYDRATE       │
   └─────────────────┘
          │
   ┌─────────────────┐
   │ ADD ZIRCONIUM   │
   │ PROPOXIDE       │
   └─────────────────┘
          │
   ┌─────────────────┐
   │ ADD TITANIUM    │
   │ ISOPROPOXIDE    │
   └─────────────────┘
          │
   ┌─────────────────┐
   │ MIX ON          │
   │ HOT PLATE       │
   └─────────────────┘
          │
   ┌─────────────────┐
   │ ADD DE-IONIZED  │
   │ WATER           │
   └─────────────────┘
          │
   ┌─────────────────┐
   │ DEPOSIT FILM    │
   │ ON SUBSTRATE    │
   └─────────────────┘
          │
   ┌─────────────────┐
   │ FIRE COATED     │
   │ SUBSTRATE       │
   │ ON HOT PLATE    │
   └─────────────────┘
          │
   ┌─────────────────┐
   │ RAPIDLY         │── 62
   │ CRYSTALIZE      │
   │ COATING IN N2   │
   │ OR FORMING GAS  │
   └─────────────────┘
```

## Fig. 3